# EUROPEAN PATENT APPLICATION

(11) **EP 2 482 351 A1**
(43) Date of publication of application: **01.08.2012**
(21) Application number: 09849671.4
(22) Date of filing: 25.09.2009
(51) Int. Cl.: H01L 33/52

(54) **SEMICONDUCTOR LIGHT-EMITTING DEVICE AND ENCAPSULATING METHOD THEREOF**

(71) Applicant: Ocean's King Lighting Science&Technology Co., Ltd., Guangdong 518054 (CN)
(72) Inventor: ZHOU, Mingjie, Shenzhen Guangdong 518054 (CN); MA, Wenbo, Shenzhen Guangdong 518054 (CN); CHEN, Guitang, Shenzhen Guangdong 518054 (CN); SHI, Chaopu, Shenzhen Guangdong 518054 (CN); QIAO, Yanbo, Shenzhen Guangdong 518054 (CN); LUO, Xi, Shenzhen Guangdong 518054 (CN)
(74) Representative: Johnson, Richard Alan
(86) International application number: PCT/CN2009/074243
(87) International publication number: WO 2011/035483

(57) **Abstract**

A semiconductor light emitting package includes a substrate, an encapsulating material, a semiconductor light emitting chip disposed on the substrate, wires; and an integrated glass-fluorescent powder compound light-emitting structure. The encapsulating material and the integrated glass-fluorescent powder compound light-emitting structure are packaged on the semiconductor light emitting chip, the integrated glass-fluorescent powder compound light-emitting structure is coated on the encapsulating material. The semiconductor light-emitting package has a large light-emitting area, high uniformity which can effectively avoid "halo" phenomenon, and long working life. The present invention also relates to a method for manufacturing semiconductor light emitting package, which can be implemented at low temperature and improve the reliability and the stability of the light-emitting property of the compound light-emitting structure.

## Description

### FIELD OF THE INVENTION

The present invention relates to a light-emitting device and, particularly, to a semiconductor light emitting package and method of manufacturing the same.

### BACKGROUND OF THE INVENTION

Conventional materials used as the luminescent matrix include fluorescent powder, nano-crystals, glass, etc. Compared to the crystals and fluorescent powder, glass has received wide attention and is used in many applications, as it is transparent and rigid, has good chemical stability and good optical properties, and is easier to be made into products with various sizes or shapes, such as displays or light sources with various sizes or shapes. Therefore, glass is widely utilized.

This luminescent glass can be used in variety of luminescent device, such as LED (light-emitting diode) light sources, light sources, flat panel display, plasma display, etc. The LED device is increasingly being used in signal light, car light, huge display screen, and lighting area due to its advantages such as longer service life, energy-saving qualities, and quick start. Currently the white light LED emits white light by a LED chip and fluorescent glue excited by light emitted from the LED chip. In a typical manufacturing method of the white light LED, the LED chip is coated by fluorescent glue after welding process. The coated LED chip is baked. The method may be used to achieve the properties of the white light LED. The method is widely used for many manufacturers. The luminous efficiency of the commercial white light LED is 801m/W.

However, the above mentioned method has some disadvantages. Firstly, high temperature and light will destroy the fluorescent powder and the organic device material. This method will cause the light degradation of the LED, and lead to shorten service life of the luminescent device. Secondly, the fluorescent powder is hard to be coated uniformly over the chip, and result in that the luminescent device has a bad uniformity of illumination, and come into being a "halo" phenomenon. Thirdly, white light LED has a glare because a very bright light in a small area. The manufacturing process of the white light LED has many processes. The baking operation of the glue wastes time and is costly.

What is needed, therefore, is a semiconductor light emitting package and method of manufacturing the same to overcome or at least alleviate the above-described problems.

### DISCLOSURE OF THE INVENTION

The present invention provides a semiconductor light emitting package which will enlarge the light-emitting area, improves the uniformity of illumination of the LED, prevents the "halo" phenomenon, and has a long service life.

The present invention also relates to a method for manufacturing semiconductor light emitting package, which has a simple process and low production cost.

A semiconductor light emitting package includes a substrate, an encapsulating material, a semiconductor light emitting chip disposed on the substrate, wires; and an integrated glass-fluorescent powder compound light-emitting structure. The encapsulating material and the integrated glass-fluorescent powder compound light-emitting structure are packaged on the semiconductor light emitting chip, the integrated glass-fluorescent powder compound light-emitting structure is coated on the encapsulating material.

The present invention further provides a method for manufacturing semiconductor light emitting package, comprising:

forming an integrated glass-fluorescent powder compound light-emitting structure;

assembling a semiconductor light emitting chip on a substrate and at least one wire soldered; and

encapsulating the semiconductor light emitting chip by the integrated glass-fluorescent powder compound light-emitting structure cooperating with the encapsulating material to coat the encapsulating material with the integrated glass-fluorescent powder compound light-emitting structure for forming the semiconductor light emitting package.

Compared with the prior art, the glass-fluorescent powder compound light-emitting structure coated on the encapsulating material has a larger area than that of the typical fluorescent powder coated on the chip. The glass-fluorescent powder compound light-emitting structure will enlarge the light-emitting area, improve the uniformity of illumination of the LED, and prevent the "halo" phenomenon. The integrated glass-fluorescent powder compound light-emitting structure can prevent the fluorescent powder dispersed in the glass from water vapor in the air and direct contact between the fluorescent powder and the organic package material. The light emitting performance will not be degraded. The life of the semiconductor light emitting package can be prolonged. The integrated glass-fluorescent powder compound light-emitting structure is coated on the encapsulating material in package process for omitting a process of the chip coated by the fluorescent powder. This method will simplify the package method, improve efficiency, and reduce production cost.

### BRIEF DESCRIPTION OF THE DRAWINGS

Many aspects of the present semiconductor light emitting package and method of manufacturing the same can be better understood with reference to the following drawings. The components in the drawings are not necessarily drawn to scale, the emphasis instead being placed upon clearly illustrating the principles of the present semiconductor light emitting package and method of manufacturing the same.

FIG. 1 is a schematic view of a semiconductor light emitting package according to a first exemplary embodiment.

FIG. 2 is schematic view of a compound light emitting structure of the semiconductor light emitting package of FIG. 1.

FIG. 3 is a flowchart of a method of manufacturing the semiconductor light emitting package of FIG. 1.

FIG. 4 is a flowchart of a method of forming the compound light emitting structure in FIG. 1.

FIG. 5 is a schematic view of a semiconductor light emitting package according to a second exemplary embodiment.

Fig. 6 is schematic view of a compound light emitting structure of the semiconductor light emitting package of FIG. 5.

Figs. 7 is a schematic view of a semiconductor light emitting package according to a third exemplary embodiment.

Fig. 8 is a schematic view of a semiconductor light emitting package according to a fourth exemplary embodiment.

### DETAILED DESCRIPTION OF THE EMBODIMENTS

For further illustrating the purposes, technical solutions and advantages of the present invention, the invention will be described in more details with reference to the drawings and examples. It should be understood that the examples are provided for illustrating rather than limiting the present invention.

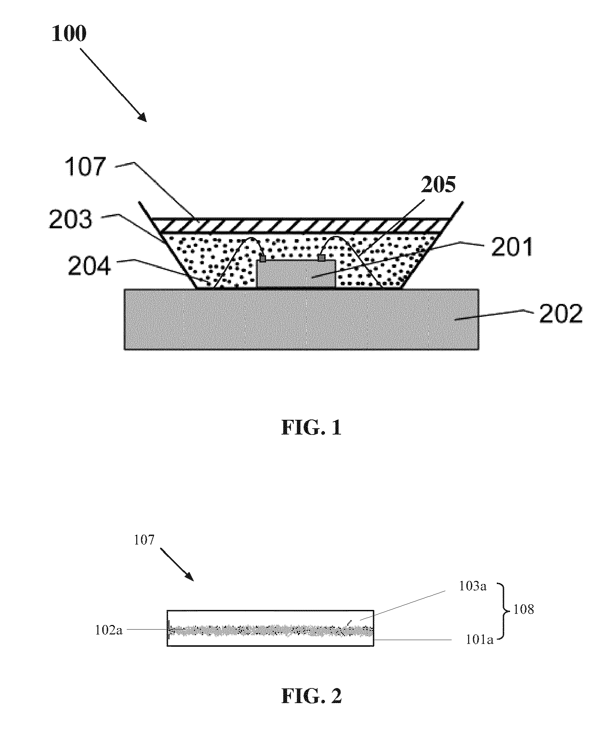

Referring to FIG. 1, a semiconductor light emitting package in accordance with a present first embodiment is illustrated. The semiconductor light emitting package 100 includes a substrate 202, an encapsulating material 204, a semiconductor light emitting chip 201, wires 205, and an integrated glass-fluorescent powder compound light-emitting structure 107. The semiconductor light emitting chip 201 is positioned on the substrate 202. The semiconductor light emitting chip 201 is packaged by the compound light-emitting structure 107 and the encapsulating material 204 together. The compound light-emitting structure 107 is coated on the encapsulating material 204.

Specifically, the semiconductor light emitting chip 201 can be a blue light LED chip capable of generating light with wavelength 420-490 nm. In alternative embodiments, the semiconductor light emitting chip 201 can be a purple light LED chip capable of generating light with wavelength 220-420 nm. In present embodiment, the semiconductor light emitting chip 201 is a blue light LED chip capable of generating light with wavelength 455 nm. The substrate 202 further includes a reflector cup 203. The semiconductor light emitting chip 201 is received in the reflector cup 203. The encapsulating material 204 is an organic transparent encapsulating material, such as a material selected from the group consisting of: epoxy resin, silicone, acrylics resin, thermoplastic material, and polyurethane material. The encapsulating material 204 is either coated or covered on the semiconductor light emitting chip 201 received in the reflector cup 203. The wires 205 are electrically connected to outer bonding pads on the substrate 202.

Referring to FIG. 2, the compound light-emitting structure 107 in accordance with a present first embodiment is illustrated. The compound light-emitting structure 107 includes a glass substrate 108 and the fluorescent powder dispersed in the glass substrate 108. The glass substrate 108 is heated to the softening point and then solidified.

A variety of suitable low-melting-point glass may be used the glass substrate 108, for example, but not limited to, borate glass , such as Na₂O-ZnO-B₂O₃-SiO₂. The appropriate melting point of the low melting point glass is 200-800° C, more preferably 200-600° C. In present embodiment, the glass substrate 108 is a sodium borosilicate glass.

In the present embodiment, the glass substrate 108 includes two pieces of glass layer 101a and 103a. The fluorescent powder embedded into the glass formed by the glass layers 101a and 103a will form a glass-fluorescent powder compound unit 102a. The fluorescent powder is approximately at center area of the glass layers 101a and 103a. The glass-fluorescent powder compound unit 102a includes glass and fluorescent powder dispersed in the glass.

In the present embodiment, the fluorescent powder can be made of a material selected from the group consisting of: red fluorescent material, green fluorescent material, and yellow fluorescent material. This fluorescent powder is stimulated by the light with wavelength of 420 ~ 490nm emitted by the blue light semiconductor light emitting chip. The red fluorescent material can be CaS:Eu, SrS:Eu or a rare-earth ion doped alkaline earth silicon nitride phosphor powder. The yellow fluorescent material can be a cerium doped yttrium aluminum garnet(YAG:Ce) phosphor powder, cerium doped terbium aluminum garnet (TAG:Ce) phosphor powder, rare-earth ion doped silicate phosphor powder or Eu²⁺-doped nitride/oxynitride phosphor powder. The green fluorescent material can be SrGa₂S₄:Eu, Ba₂SiO₄:Eu , etc. A portion of the blue light emitted by the semiconductor light emitting chip 201 stimulates the glass-fluorescent powder compound light-emitting material to generate fluorescent light. This combination of fluorescent light and the other portion of blue light produces is white light. In the present embodiment, the fluorescent powder is YAG:Ce phosphor powder. The fluorescent powder can be a commercial fluorescent powder (LMY-65-C produced by Dalian Luminglight Co., Ltd.).

In alternative embodiments, the fluorescent powder can be selected a material from the group consisting of: red fluorescent material, green fluorescent material, and yellow fluorescent material. This fluorescent powder is stimulated by the light with wavelength of 220 ~ 420nm emitted by the purple light semiconductor light emitting chip. The red fluorescent material can be Y₂O₃:Eu³⁺, Y₂O₂S:Eu³⁺ or a rare-earth ion doped tungstate, molybdate, gallate, silicate, aluminate, vanadate, and borate , etc. The yellow fluorescent material can be a cerium doped yttrium aluminum garnet(YAG:Ce) phosphor powder or cerium doped terbium aluminum garnet(TAG : Ce) phosphor powder. The green fluorescent material can be CaO·0.53SiO₂·0.36Al₂O₃:Ce, Tb, ZnS:Cu,Al,Au, Y₂SiO₅:Ce,Tb, MgAl₁₁O₁₉:Ce,Tb, Ca₈Mg(SiO₄)Cl₂:Eu²⁺, LaPO₄:Ce,Tb, La₂O₃·0.2SiO₂·0.9P₂O₅:Ce,Tb, GdMgB₅O₁₀: Ce,Tb,Mn²⁺, Y₂O₃·Al₂O₃:Tb, MgGa₂O₄:Mn²⁺, BaMg₂Al₁₆O₂₇:Eu²⁺,Mn²⁺, (Ba,Sr,Ca)₂SiO₄:Eu²⁺ or Zn₂SiO₄:Mn²⁺, etc. The blue fluorescent material can be BaMg₂Al₁₆O₂₇:Eu²⁺, BaMgAl₁₀O₁₇:Eu²⁺, ZnS:Ag, CaO·0.53SiO₂·0.36Al₂O₃:Ce, (Sr,Ca,Mg)₁₀(PO₄)₆Cl₂:Eu²⁺, Ca₂B₅O₉Cl:Eu²⁺, Ba₃MgSi₂O₈:Eu²⁺, (Sr,Ca)₁₀(PO₄)₆·nB₂O₃:Eu²⁺, BaAl₈O₁₃:Eu²⁺, 2SrO·0.84P₂O₅·0.16B₂O₃:Eu⁺², Sr₂Si₃O₈·2SrCl₂:Eu²⁺ or Y₂SiO5:Ce , etc. In present embodiment, the fluorescent powder is a mixture of three kinds of fluorescent powder (BaMgAl₁₀O₁₇:Eu²⁺, CaO·0.53SiO₂.0.36Al₂O₃:Ce,Tb and Y₂O₂S:Eu³⁺ ). The mass ratio of them is 0.7:16:40.

As shown in FIGS. 1 and 2, the appropriate shape of the compound light-emitting structure 107 is a flat panel structure. The compound light-emitting structure 107 is coated on the encapsulating material 204 and stands on the inner surface of the reflector cup 203. The reflector cup 203 can be cup shaped or bowl shaped. The compound light-emitting structure 107 can be sealedly connected with the reflector cup 203. In this embodiment, the compound light-emitting structure 107 is a flat panel. The compound light-emitting structure 107 is stimulated by the blue light or purple light emitted by the semiconductor light emitting chip 201 to generate a light in an area. The compound light-emitting structure 107 can be considered as an area light source. This structure will enlarge light area and provide uniform light to prevent the "halo" phenomenon. The compound light-emitting structure 107 can be coated by encapsulating material, such as epoxy resin, silicone, acrylics resin, thermoplastic material, and polyurethane material, etc to form a seal protection.

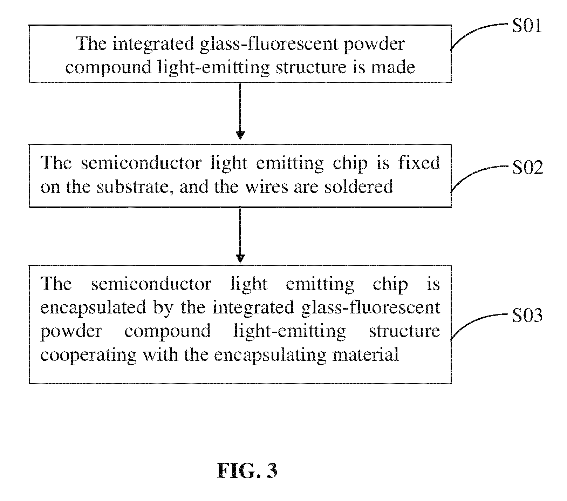

As shown in FIGS. 1 and 3, a manufacturing method of the semiconductor light emitting package includes the steps S01 through S03:

In step S01, the integrated glass-fluorescent powder compound light-emitting structure is made.

In step S02, the semiconductor light emitting chip is fixed on the substrate. Then the wires are soldered.

In step S03, the semiconductor light emitting chip is packaged by the integrated glass-fluorescent powder compound light-emitting structure cooperating with the encapsulating material. The compound light-emitting structure is coated on the encapsulating material to form the semiconductor light emitting package.

In alternative embodiments, the order of the steps S01 through S03 can be changed, but ensure that the step S01 is stayed ahead the step S03

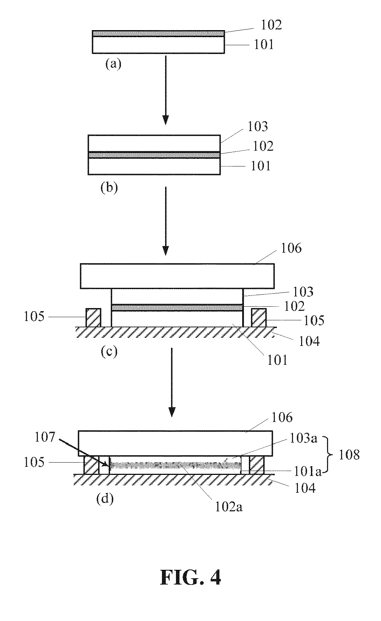

The compound light-emitting structure in the step S01 is formed by heating a glass containing the fluorescent powder to the softening point. As shown in FIG. 4, a manufacturing method of the compound light-emitting structure includes the following steps:

The fluorescent powder is formed on a first glass panel 101 to form a fluorescent powder layer 102.

A second glass 103 is positioned on the fluorescent powder layer 102 which has located on the first glass panel 101.

The first glass panel 101 and the second glass 103 are heated to the softening point to disperse the fluorescent powder in the first glass panel 101 and the second glass 103, and then solidified to form the integrated glass-fluorescent powder compound light-emitting structure 107.

As shown in FIG. 4(a), the appropriate thickness of the first glass panel 101 is 0.3-3 mm in the step of forming the fluorescent powder layer 102, more preferably 0.5-1mm. The first glass panel 101 can be any low melting point glass, such as sodium borosilicate glasses. The appropriate melting point of the low melting point glass is 200-800° C, preferably 200-600° C. The appropriate thickness of the fluorescent powder layer 102 is 5-80 micrometers, preferably 10-40 micrometers. The fluorescent powder can be made from at least one of the above-described fluorescent powder. In the present embodiment, the fluorescent powder is YAG:Ce phosphor powder. The fluorescent powder can be a commercial fluorescent powder (LMY-65-C produced by Dalian Luminglight Co., Ltd.).

The fluorescent powder layer 102 is formed by coating process, deposition process or spraying process. For example, the fluorescent powder layer 102 is coated on the first glass panel 101 by screen printing technology. The compound light emitting structure made by the mature screen printing technology can be produced in mass production to increase productivity.

The first glass panel 101 can be under pre-process into a flat panel by some processes, such as cutting to a needed shape, grinding process, and polishing process. In alternative embodiments, the thickness of the first glass panel 101 is 0.5 mm, and the size is 3x3 cm².

As shown in FIG. 4(b), the fluorescent powder layer 102 is disposed between the second glass 103 and the first glass panel 101 in interlayer step. The material of the second glass 103 is the same with that of the first glass panel 101. Understandably, the material of the second glass 103 can be different from that of the first glass panel 101 in the other embodiments. In present embodiment, the structure, the size and the material of the second glass 103 is the same with that of the first glass panel 101. The second glass 103 is under pre-process too. If the material of the second glass 103 can be different from that of the first glass panel 101, the size and the structure of the second glass 103 can be different from that of the first glass panel 101. One of the second glass 103 and the first glass panel 101 can be doped with specific chemical material (such as rare-earth element) to have different colors for satisfying different acquire. This method of the present embodiment can produce the light-emitting structure 107 with at least two layers with different materials, different sizes, or different doped materials. The typical method cannot make that type of the light-emitting structure 107.

The first glass panel 101 is disposed on a table such as a flat metal panel 104. At least one of spacers 105 are arranged around or disposed on the two opposite sides of the first glass panel 101 and the second glass 103. The thickness of the spacer 105 is adjustable. When the first glass panel 101 and the second glass 103 pressed by the pressing block 106 are heated to the softening point, the spacer 105 is used for ensuring that the thickness of the light-emitting structure 107 has a presetting final thickness. An integrated structure as seen in FIG. 4(c) is placed into an electric furnace, and keeps 530° C in 90 minutes to soften first glass panel 101 and the second glass 103 pressed by the pressing block 106_{∘} The first glass panel 101 and the second glass 103 are integrated to the glass substrate 108 doped with fluorescent powder. Referring to FIGS. 4(d) and 2, the integrated glass-fluorescent powder compound light-emitting structure 107 doped with fluorescent powder is formed after cooling solidification. The first glass panel 101 and the second glass 103 are formed the glass layers 101a and 103a respectively. The fluorescent powder layer 102 is embedded between the first glass panel 101 and the second glass 103 to form the glass-fluorescent powder compound unit 102a.

In the above mentioned method of forming the compound light-emitting structure 107, the first glass panel 101 and the second glass 103 is used to prevent the fluorescent powder dispersed in the glass from water vapor in the air because the glass can be chosen flexibly, a high transparent performance, a good machinable performance, an air-tight and a chemical stability. The light emitting performance will not be degraded. The performance of the fluorescent powder will be degraded because the highest heat-resistant temperature of the fluorescent powder is higher than the softening point of the glass.

Moreover, the heating temperature of the above mentioned method is under the softening point of the glass, but not under a high melting temperature. The fluorescent powder will not be destroyed in the heating process so that it will improve the reliability and the stability of the light-emitting property of the compound light-emitting structure. The total produce process is simple and efficient because the process do not need complicated equipment and complicated parameter adjustment. The compound light-emitting structure 107 will have a longer life because the fluorescent powder do not suffer high temperature and be irradiated by light. The fluorescent powder can be uniformly dispersed in the glass to enhance light uniformity and light consistency and avoid "halo" phenomenon.

In typical device method, the fluorescent powder is mixed with resin. This typical device method will make the fluorescent powder agglomerate or nonuniformly disperse and affect light uniformity and light consistency of different batches of the products. In present embodiment, the fluorescent powder of the integrated glass-fluorescent powder compound light-emitting structure 107 is uniformly dispersed in the glass substrate. The uniformity of different batches of the products can be the same by controlling the coating amount of the fluorescent powder.

In step S02 of soldering wires, the LED semiconductor light emitting chip 201 is fixed on the reflector cup 203 disposed on the substrate 202. The semiconductor light emitting chip 201 is filled with the silicone (encapsulating material) 204 to encapsulate the semiconductor light emitting chip 201. The compound light-emitting structure 107 obtained from the above mentioned method is coated on the silicone 204. The silicone 204 is solidified. Specifically, the device structure packaged is placed into oven. The device structure is pre-solidified for 1-4 hours under 100-130°C at first. A semiconductor light emitting package 100 is produced when the device structure is re-solidified for 1-8 hours under 140-170°C to solidify the device structure absolutely. In present embodiment, the temperature of the pre-solidify process is 120 °C , and the pre-solidify time is 2 hours. The temperature of the re-solidify process is 160°C, and the re-solidify time is 2 hours. The compound light-emitting structure 107 can be packaged again. The compound light-emitting structure 107 can be coated by the encapsulating material, such as silicone, epoxy, acrylics, thermoplastic material, and polyurethane material, etc.

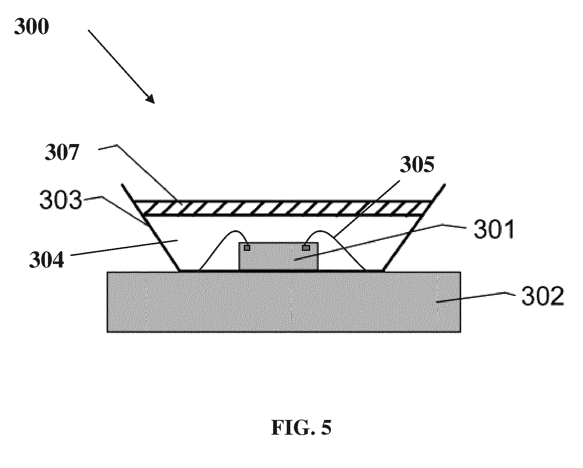

Referring to FIG. 5, a semiconductor light emitting package 300, according to a second exemplary embodiment, is shown. The semiconductor light emitting package 300 includes a substrate 302, an encapsulating material 304, a semiconductor light emitting chip 301, wires 305, and an integrated glass-fluorescent powder compound light-emitting structure 307. The semiconductor light emitting chip 301 is positioned on the substrate 302. The semiconductor light emitting chip 301 is packaged by the compound light-emitting structure 307 and the encapsulating material 304 together. The compound light-emitting structure 307 is coated on the encapsulating material 304. The substrate 302 includes a reflector cup 303. In an alternative embodiment, the reflector cup 303 is integral with the substrate 302.

The semiconductor light emitting package 300 of the second embodiment is similar to the semiconductor light emitting package 100 of the first embodiment, except for the encapsulating material 304, the compound light-emitting structure 307, and the semiconductor light emitting chip 301. In present embodiment, the encapsulating material 304 is an inert gas 304. The glass substrate of the compound light-emitting structure 307 is a Li- Zn-Si system glass. The fluorescent powder is coated though deposition coating method. The fluorescent powder is mixture of a yellow YAG:Ce fluorescent powder and a red CaS:Eu fluorescent powder. The mass ratio of them is 2:5.

A method of manufacturing the semiconductor light emitting package 300 of the second embodiment is similar to the method of manufacturing the semiconductor light emitting package 100 of the first embodiment, except for the steps S01 and S03.

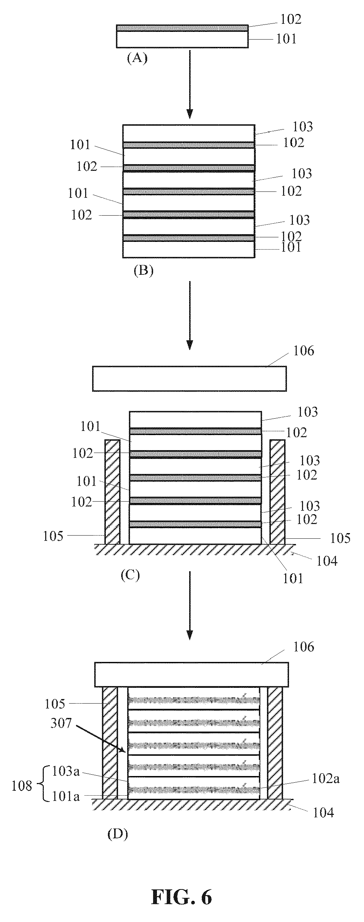

Referring to FIG. 6, a flowchart of a method of manufacturing the integrated glass-fluorescent powder compound light-emitting structure 307. In the present embodiment, the method substantially includes each step of the method of manufacturing the compound light-emitting structure 107 of the first embodiment, except for a step forming a fluorescent powder layer and the fluorescent powder layer disposed between two glass layers again after the first interlayer step. This method forms a structure with multi-layer glass and fluorescent powder interlayer. The label of the FIG. 6 is the same as that of the FIG. 4. The glass 101, 103 and the fluorescent powder layer 102 are arranged to sequentially overlap each other to cooperatively form the structure in the FIG. 6. Five layers structure is shown in the FIG. 6. In other embodiments, the amount of layers is changeable. The repeated glass panel can be the first glass panel 101 or the second glass 103 in different situations. The size, the material, and the different doped element of the second glass 103 can be different from that of the first glass panel 101 for satisfying different acquire. Each fluorescent powder layers can have different thickness, material and other element to produce a variety compound light emitting structure.

Referring to FIGS. 6(C) and 6(D), the manufacturing steps are similar to the steps of FIG. 4, except that the multi-layer glass compound is heated and pressed instead. The compound light emitting structure with multi-layer fluorescent powder forms after cooling solidification.

The doping ratio, the thickness, and the transparent factory of the compound light emitting structure can be controlled through adjusting the coating thickness of the fluorescent powder and the number of the glass panel.

In the step S03 of the second embodiment, the compound light-emitting structure 307 is sealedly connected with the reflector cup 303 at first. The compound light-emitting structure 307 can be covered on the inner surface of the reflector cup 303. The compound light-emitting structure 307, the reflector cup 303, and the substrate 302 are used for enclosing a seal space. The seal space is filled with the inert gas 304 such as nitrogen, argon, etc to produce the semiconductor light emitting package 300. Solidification process is omitted because the semiconductor light emitting chip 301 is not packaged by the organic package material. The device method of the second embodiment can omit a process of the chip coated by the fluorescent powder and a process of the chip packaged by the organic package material. This method simplifies the package steps, improves efficiency, reduces production cost, prevents aging of the organic package material and the fluorescent powder, and has a longer life.

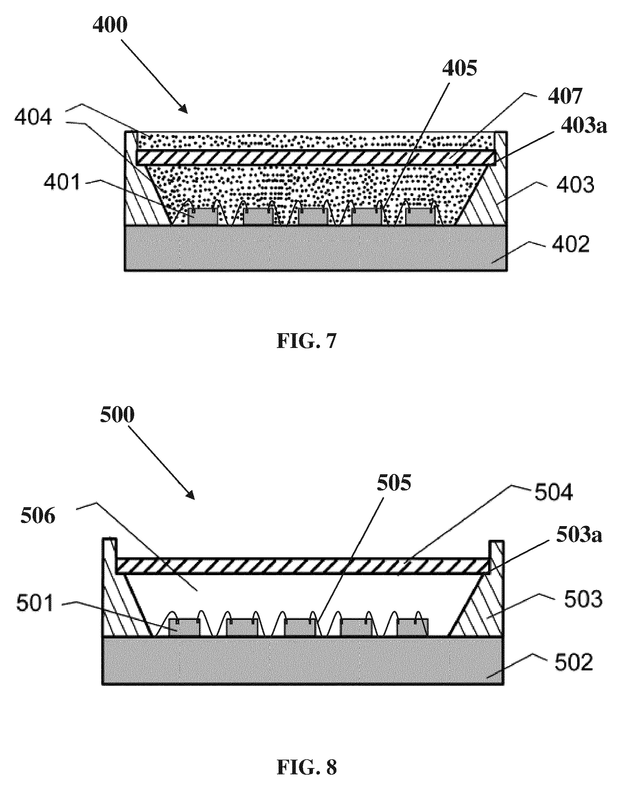

Referring to FIG. 7, a semiconductor light emitting package 400, according to a third exemplary embodiment, is shown. The semiconductor light emitting package 400 includes a substrate 402, an encapsulating material 404, a semiconductor light emitting chip 401, wires 405, and an integrated glass-fluorescent powder compound light-emitting structure 407. The semiconductor light emitting chip 401 is positioned on the substrate 402. The semiconductor light emitting chip 401 is packaged by the compound light-emitting structure 407 and the encapsulating material 404 together. The compound light-emitting structure 407 is coated on the encapsulating material 404. The substrate 402 includes a reflector cup 403.

The semiconductor light emitting package 400 of the third embodiment is similar to the semiconductor light emitting package 100 of the first embodiment, except for the following aspects. In present embodiment, the glass substrate of the compound light-emitting structure 407 is a sodium-boron-aluminum system glass. The fluorescent powder is coated though spraying coating method. The fluorescent powder is a yellow silicate fluorescent powder(LMS-560-B produced by Dalian Luminglight Co., Ltd.). The semiconductor light emitting chip is a 5×5 arrays blue light LED chips capable of generating light with wavelength of 420 nm. The encapsulating material 404 not only packages the chip 401, but also packages the compound light-emitting structure 407. The reflector cup 403 further includes a step structure 403a. The compound light-emitting structure 407 is disposed on the step structure 403a.

A method of manufacturing the semiconductor light emitting package 300 is similar to the method of manufacturing the semiconductor light emitting package 100 of the first embodiment, except for the number of the chip 401 packaged.

Referring to FIG. 8, a semiconductor light emitting package 500, according to a fourth exemplary embodiment, is shown. The semiconductor light emitting package 500 includes a substrate 502, an encapsulating material 506, a semiconductor light emitting chip 501, an integrated glass-fluorescent powder compound light-emitting structure 504, and wires 505. The semiconductor light emitting chip 501 is positioned on the substrate 502. The semiconductor light emitting chip 501 is packaged by the compound light-emitting structure 504 and the encapsulating material 506 together. The encapsulating material 504 is coated on the encapsulating material 506. The substrate 502 includes a reflector cup 503. The reflector cup 503 includes a step structure 503a for holding the compound light-emitting structure 504.

The semiconductor light emitting package 500 of the fourth embodiment is similar to the semiconductor light emitting package 300 of the third embodiment, except for the following aspects. In present embodiment, the encapsulating material 506 is an inert gas. The glass substrate of the compound light-emitting structure 504 is a tellurate glass. The fluorescent powder is a mixture of three kinds of fluorescent powder (BaMgAl₁₀O₁₇:Eu²⁺, CaO·0.53SiO₂·0.36Al₂O₃:Ce,Tb and Y₂O₂S:Eu³⁺ ). The mass ratio of them is 24.4:33.6:42. The semiconductor light emitting chip is a 5×5 arrays purple light LED chips capable of generating light with wavelength of 395 nm.

A method of manufacturing the semiconductor light emitting package 500 is similar to the method of manufacturing the semiconductor light emitting package 300 of the second embodiment, except for the number of the chip 501 packaged.

The glass-fluorescent powder compound light-emitting structure coated on the encapsulating material of the above-described embodiments has a larger area than that of the typical fluorescent powder coated on the chip. The glass-fluorescent powder compound light-emitting structure will enlarge the light-emitting area, improves the uniformity of illumination of the LED, and prevents the "halo" phenomenon. The integrated glass-fluorescent powder compound light-emitting structure can prevent the fluorescent powder dispersed in the glass from water vapor in the air and direct contact between the fluorescent powder and the organic package material. The light emitting performance will not be degraded. The life of the semiconductor light emitting package can be prolonged. The integrated glass-fluorescent powder compound light-emitting structure is coated on the encapsulating material in package process for omitting a process of the chip coated by the fluorescent powder. This method will simplify the package method, improve efficiency, and reduce production cost.

While the invention has been described in connection with what are presently considered to be the most practical and preferred embodiments, it is to be understood that the invention is not to be limited to the disclosed embodiments, but on the contrary, is intended to cover various modifications and equivalent arrangements included within the spirit and scope of the invention.

## Claims

1. A semiconductor light emitting package comprising:
a substrate;
an encapsulating material;
a semiconductor light emitting chip disposed on the substrate;
wires; and
an integrated glass-fluorescent powder compound light-emitting structure;
wherein the encapsulating material and the integrated glass-fluorescent powder compound light-emitting structure are packaged on the semiconductor light emitting chip, the integrated glass-fluorescent powder compound light-emitting structure is coated on the encapsulating material.

2. The semiconductor light emitting package as claimed in claim 1, wherein the integrated glass-fluorescent powder compound light-emitting structure comprises a glass substrate and the fluorescent powder dispersed in a section of the glass substrate, the glass is heated to the softening point and then solidified.

3. The semiconductor light emitting package as claimed in claim 1, wherein the semiconductor light emitting chip is a chip capable of generating blue light or purple light, the fluorescent powder of the integrated glass-fluorescent powder compound light-emitting structure is stimulated by the light emitted by the chip capable of generating blue light or purple light.

4. The semiconductor light emitting package as claimed in claim 3, wherein the semiconductor light emitting chip is a chip capable of generating blue light, the fluorescent powder stimulated by blue light emitted by the semiconductor light emitting chip is one selected from the group consisting of a red fluorescent material, a green fluorescent material, and a yellow fluorescent material.

5. The semiconductor light emitting package as claimed in claim 3, wherein the fluorescent powder stimulated by purple light emitted by the semiconductor light emitting chip is one selected from the group consisting of a red fluorescent material, a green fluorescent material, and a yellow fluorescent material.

6. The semiconductor light emitting package as claimed in claim 1, wherein the integrated glass-fluorescent powder compound light-emitting structure is a flat panel structure, the integrated glass-fluorescent powder compound light-emitting structure is stimulated by the light emitted by the semiconductor light emitting chip to generate an area light source.

7. A method for manufacturing a semiconductor light emitting package, comprising the steps of:
forming an integrated glass-fluorescent powder compound light-emitting structure;
assembling a semiconductor light emitting chip on a substrate and at least one wire soldered; and
encapsulating the semiconductor light emitting chip by the integrated glass-fluorescent powder compound light-emitting structure cooperating with the encapsulating material to coat the encapsulating material with the integrated glass-fluorescent powder compound light-emitting structure for forming the semiconductor light emitting package.

8. The method as claimed in claim 7, further comprising heating a glass containing the fluorescent powder to the softening point and solidifying the glass for forming the integrated glass-fluorescent powder compound light-emitting structure.

9. The method as claimed in claim 7, wherein the steps of forming the integrated glass-fluorescent powder compound light-emitting structure comprises the steps of:
coating the fluorescent powder on a first glass panel for forming a fluorescent powder layer;
disposing a second glass on the fluorescent powder layer for containing the fluorescent powder layer with the first glass panel; and
heating the first glass panel and the second glass to the softening point for dispersing the fluorescent powder in the first glass panel and the second glass, and then solidifying for forming the integrated glass-fluorescent powder compound light-emitting structure.

10. The method as claimed in claim 9, further comprising a plurality of the step of coating the fluorescent powder on a first glass panel for forming a fluorescent powder layer, and step of disposing a second glass on the fluorescent powder layer for containing the fluorescent powder layer with the first glass panel after the step of disposing a second glass on the fluorescent powder layer for containing the fluorescent powder layer with the first glass panel to form a structure with multi-layer glasses and fluorescent powder interlayers, the structure with multi-layer glasses and fluorescent powder interlayers is heated to the softening point, and then solidified for forming the integrated glass-fluorescent powder compound light-emitting structure.

11. The method as claimed in claim 7, wherein the encapsulating material is an organic package material, the step of the encapsulating the semiconductor light emitting chip by the integrated glass-fluorescent powder compound light-emitting structure cooperating with the encapsulating material to coat the encapsulating material with the integrated glass-fluorescent powder compound light-emitting structure for forming the semiconductor light emitting package further comprises:
encapsulating the semiconductor light emitting chip by the organic package material;
coating the organic package material with the integrated glass-fluorescent powder compound light-emitting structure;
solidifying the organic package material.

12. The method as claimed in claim 7, wherein the encapsulating material is an inert gas, the step of the encapsulating the semiconductor light emitting chip by the integrated glass-fluorescent powder compound light-emitting structure cooperating with the encapsulating material to coat the encapsulating material with the integrated glass-fluorescent powder compound light-emitting structure for forming the semiconductor light emitting package further comprises:
mounting the integrated glass-fluorescent powder compound light-emitting structure on the substrate to enclose a seal space for receiving the semiconductor light emitting chip, the seal space filled with the inert gas.
